(19) Europäisches Patentamt
European Patent Office
Office européen des brevets

(11) **EP 1 422 740 B1**

(12) **EUROPÄISCHE PATENTSCHRIFT**

(45) Veröffentlichungstag und Bekanntmachung des Hinweises auf die Patenterteilung:
**19.08.2009  Patentblatt 2009/34**

(51) Int Cl.:
*H01J 37/02* (2006.01)     *H01J 37/06* (2006.01)
*H01J 43/02* (2006.01)     *H01J 37/05* (2006.01)

(21) Anmeldenummer: **03026056.6**

(22) Anmeldetag: **12.11.2003**

(54) **Vorrichtung zum Erzeugen von Sekundärelektronen, insbesondere Sekundärelektrode und Beschleunigungselektrode**

Device for generating secondary electrons, secondary electrode and accelerating electrode

Dispositif pour la production d'électrons secondaires, électrode secondaire et électrode d'accélération

(84) Benannte Vertragsstaaten:
**DE FR IT**

(30) Priorität: **21.11.2002  DE 10254416**

(43) Veröffentlichungstag der Anmeldung:
**26.05.2004  Patentblatt 2004/22**

(73) Patentinhaber: **Infineon Technologies AG**
**81669 München (DE)**

(72) Erfinder: **Kyek, Andreas**
**93161 Sinzing (DE)**

(74) Vertreter: **Kindermann, Peter**
**Kindermann Patentanwälte**
**Postfach 100234**
**85593 Baldham (DE)**

(56) Entgegenhaltungen:
| | |
|---|---|
| DE-A1- 2 707 416 | GB-A- 503 211 |
| JP-A- 6 267 493 | JP-A- 60 079 655 |
| JP-A- 62 058 536 | US-A- 3 395 306 |
| US-A- 3 976 905 | US-A- 4 914 292 |
| US-A- 5 164 599 | US-A- 6 043 499 |

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

**Beschreibung**

Die Erfindung betrifft eine Vorrichtung zum Erzeugen von Sekundärelektronen, die folgende Bestandteile enthält:

- eine Primärelektrode, mit deren Hilfe sich Primärelektronen erzeugen lassen, und
- eine Beschleunigungselektrode, mit deren Hilfe sich die Primärelektronen beschleunigen lassen.

Die Vorrichtung wird bspw. an einen Freiraum angeordnet, der bspw. zum Durchtritt eines Ionenstrahls, zur Aufnahme eines Plasmas und/oder zur Aufnahme eines Werkstücks bzw. eines zu bearbeitenden Materials dient.

Die Primärelektrode ist beispielsweise ein sehr dünner Draht mit einem sehr kleinen Krümmungsradius. Aufgrund des Krümmungsradius entsteht eine Koronaentladung. In ausreichendem Abstand von der Primärelektrode treten aufgrund der Koronaentladung nur Ladungen von der Polarität der Elektrode auf. Das bedeutet, dass die Primärelektrode zum Erzeugen von Elektronen ein negatives Potential besitzt. Beispielsweise beträgt der Durchmesser des Primärelektrodendrahtes 30 $\mu$m (Mikrometer).

Die Beschleunigungselektrode liegt auf einem anderen Potential als die Primärelektrode, beispielsweise auf Massepotential. Durch das sich zwischen der Beschleunigungselektrode und der Primärelektrode ausbildende elektrische Feld werden die Primärelektronen zur Beschleunigungselektrode hin beschleunigt. Die Primärelektronen treten durch Öffnungen in der Beschleunigungselektrode hindurch und behalten aufgrund des fehlenden elektrischen Beschleunigungsfeldes hinter der Beschleunigungselektrode ihre Richtung bei.

Beispielsweise werden solche Vorrichtungen zum Erzeugen von Sekundärelektronen in Ionenimplantationsanlagen bei der Herstellung von integrierten Schaltkreisen eingesetzt, um Aufladungen entgegenzuwirken, die auf einem Wafer durch die Kationen entstehen können.

Aus den Dokumenten US-A-6 043 499, JP 06 267493, US-A-5 164 599 und US-A-4 914 292 sind Ionenimplantationsanlagen bekannt in denen Sekundärelektronen eingesetzt werden, um Aufladungen entgegenzuwirken. Aus den Dokumenten US-A-3395 306, JP 62 058536, DE 27 07 416 A1, US-A-3 976 905 und GB 503 211 A sind Elektronenvervielfacher bekannt.

Es ist Aufgabe der Erfindung, eine einfach aufgebaute Vorrichtung zum Erzeugen von Sekundärelektronen anzugeben, die insbesondere Aufladungen auf wirksame Weise entgegenwirkt oder solche Aufladungen wirksam verhindert.

Die auf die Vorrichtung gerichtete Aufgabe wird durch eine Vorrichtung mit den im Patentanspruch 1 angegebenen Merkmalen gelöst. Weiterbildungen sind in den Unteransprüchen angegeben.

Die Erfindung geht von der Überlegung aus, dass die Primärelektronen aufgrund der Beschleunigungsspannung eine vergleichsweise hohe Energie haben, beispielsweise mehrere 100 eV (Elektronenvolt). Aufgrund der hohen Energie besteht beispielsweise die Möglichkeit, dass Primärelektronen die direkt zu einem Halbleiter-Wafer gelangen dort eine starke negative Aufladung bewirken, die ebenfalls nicht gewollt ist. Beispielsweise können die Primärelektronen von einem Ionenstrahl mitgerissen werden.

Bei der Erfindung enthält die Vorrichtung zum Erzeugen von Sekundärelektronen zusätzlich zu der Beschleunigungselektrode und zur Primärelektrode eine Sekundärelektrode, die beim Auftreffen von Primärelektronen Sekundärelektronen erzeugt. Die Sekundärelektrode ist auf der von der Primärelektrode abgewandten Seite der Beschleunigungselektrode angeordnet. Damit liegt die Sekundärelektrode zwischen der Beschleunigungselektrode und dem Freiraum . Auf der Sekundärelektrode treffen Primärelektronen auf und erzeugen Sekundärelektronen. Weil die Sekundärelektrode von der Beschleunigungselektrode räumlich getrennt ist, gelangen die Sekundärelektronen ohne Störungen aufgrund des elektrischen Feldes zum Erzeugen der Primärelektronen und zu deren Beschleunigung nach außen, z.B. zum Freiraum. Weil die Sekundärelektrode außerdem auf der gleichen Seite des Freiraums liegt, wie die Primärelektrode wird die Anzahl von Primärelektronen verringert, die den Freiraum erreichen.

Die Sekundärelektrode enthält mindestens eine Durchgangsöffnung, die sich schräg durch die Sekundärelektrode hindurch erstreckt. Damit treffen die Primärelektronen auf eine Seitenwand der Durchgangsöffnung, bevor sie die Vorrichtung verlassen und z.B. den Freiraum erreichen. Weiterhin werden beim Auftreffen der Primärelektronen Sekundärelektronen erzeugt, die eine vergleichsweise kleine Energie haben. Außerdem verlängert sich die Durchgangsöffnung auf Grund der Schräglage über die Materialdicke der Elektrode hinaus. Die Sekundärelektrode hat eine Doppelfunktion, nämlich:

- Erzeugung der Sekundärelektronen beim Auftreffen von Primärelektronen, und
- Unterbrechen des direkten Weges von Primärelektronen nach außen, z.B. zum Freiraum.

Zusätzlich zu einer sich schräg durch die Sekundärelektrode hindurch erstreckenden Durchgangsöffnung lassen sich auch andere Maßnahmen treffen, um mit Hilfe der Durchgangsöffnung den Durchtritt von Primärelektronen zu behindern oder zu verhindern.

Bei einer Weiterbildung ist die Durchgangsöffnung ein Langloch, dass sich vorzugsweise parallel zur Primärelektrode bzw. zu einem Draht der Primärelektrode erstreckt. Das Langloch lässt sich beispielsweise mit Hilfe einer Fräsmaschine auf einfache Art und Weise herstellen. Die Herstellung von schrägen Langlöchern ist mit einer Fräsmaschine ohne weiteres möglich. Alternativ werden Lamellen verwendet.

Bei einer Ausgestaltung liegen die Seitenflächen der Durchgangsöffnung in der Auftreffrichtung des Hauptteils der in die Durchgangsöffnung gelangenden Primärelektronen einander überlappend oder fluchtend. Durch eine fluchtende Anordnung wird erreicht, dass einerseits keine Primärelektronen direkt nach außen, z.B. zum Freiraum, gelangen und dass andererseits die Auftrefffläche in der Durchgangsöffnung im Verhältnis zur Länge der Durchgangsöffnung groß ist. Damit können viele Sekundärelektronen auf einfache Art durch die Durchgangsöffnung hindurch nach außen, z.B. zum Freiraum, gelangen.

Bei einer Weiterbildung ist die Durchgangsöffnung in einem Winkel zwischen 30° und 70° zur Flächennormalen der Elektrode im Bereich der Durchgangsöffnung geneigt angeordnet. Der geeignete Winkel hängt von der Dicke der Elektrode ab. Bei einer Dicke von etwa 5 mm ist beispielsweise ein Winkel von 55° besonders geeignet. Bei einer Ausgestaltung gilt für den Winkel:

$$\tan(90°\text{-}w) = d/b,$$

wobei w den Winkel, d die Dicke der Elektrode mit der Durchgangsöffnung und b die Breite der Durchgangsöffnung bezeichnen.

Bei einer Ausgestaltung liegt der Abstand zwischen den Seitenwänden der Durchgangsöffnung zwischen 2 mm und 6 mm. Der geeignete Abstand hängt auch von der Dicke der Elektrode mit der Durchgangsöffnung ab. Beispielsweise ist bei einer Elektrodendicke von etwa 5 mm und einem Neigungswinkel von 55° ein Abstand zwischen den Seitenwänden von 4 mm besonders geeignet.

Bei einer anderen Weiterbildung ist pro Primärelektrode nur eine Durchgangsöffnung vorgesehen. Dadurch ergibt sich eine einfach aufgebaute Vorrichtung. Bei einer Ausgestaltung enthält die Vorrichtung nur eine Primärelektrode. Durch diese Maßnahme vereinfacht sich der Aufbau der Vorrichtung weiter.

Alternativ enthält die Vorrichtung jedoch mehrere Primärelektroden, denen jeweils mindestens eine Durchgangsöffnung zugeordnet ist. Durch unterschiedliche Durchtrittsrichtungen der Durchgangsöffnungen lassen sich die von den Primärelektronen verschiedener Primärelektroden erzeugten Sekundärelektroden an einer bestimmten Stelle außerhalb der Vorrichtung, z.B. im Freiraum konzentrieren, z.B. in einer Elektronenwolke. Dadurch wird bei gleichbleibender Baulänge und gleicher Neutralisierungswirkung gewährleistet, dass weniger Primärelektronen bspw. zum Auftreffort des Ionenstrahls gelangen können, d.h. bspw. zum Halbleiterwafer oder zu einem zu bestrahlenden Werkstoff.

Als Material für die Elektrode mit der Durchgangsöffnung wird bei einer anderen Weiterbildung Aluminium, eine Aluminiumlegierung, Graphit, eine Graphitverbindung oder Aluminiumoxid $Al_2O_3$ verwendet. Aluminium Al und Graphit C haben bei Energien von 300 eV eine Ausbeute von 1 oder doch von der Größenordnung 1. Das bedeutet, dass jedes auftreffende Primärelektron ein Sekundärelektron erzeugt. Die Ausbeute wird auch als Sekundärelektronenemissionskoeffizient bezeichnet. Der Sekundärelektronenemissionskoeffizient von Aluminiumoxid ist mindestens doppelt so hoch wie der von Aluminium bzw. Graphit.

Eine aufgeraute Oberfläche der Elektrode mit der Durchgangsöffnung führt zu einer höheren Sekundärelektronenemission. Bei einer Ausgestaltung beträgt die mittlere Rauheit der Oberfläche 6,3 $\mu$m.

Die Beschleunigungselektrode enthält mehr als 100, bei einer Weiterbildung mehr als 500 oder sogar mehr als 1000 Öffnungen. Die Öffnungen sind beispielsweise Bohrungen mit einem Durchmesser von etwa 1 mm. Alternativ lassen sich jedoch auch Drahtgitter einsetzen.

Bei einer Weiterbildung wird als Material für die Beschleunigungselektrode Aluminium oder eine Aluminiumlegierung eingesetzt. Bei einer Ausgestaltung wird Aluminium mit einer Reinheit von 99,9 % oder mehr als 99,9 % eingesetzt. Dieses Material ist insbesondere bei der Herstellung von integrierten Schaltungsanordnungen als Elektrodenmaterial geeignet. Die mittlere Oberflächenrauheit der Beschleunigungselektrode beträgt bei einer Ausgestaltung 4,3 $\mu$m, d.h. die Beschleunigungselektrode ist glatter als die Sekundärelektrode.

Bei einer Weiterbildung ist die Primärelektrode bzw. sind die Primärelektroden parallel zur Ausbreitungsrichtung des Ionenstrahls angeordnet. Diese Art der Anordnung wird insbesondere bei sogenannten Hochstrom-Ionenimplantierungsanlagen eingesetzt. In diesen Anlagen ist der Strom des Ionenstrahls größer als 1 mA. Beispielsweise liegt der Ionenstrom im Bereich zwischen 1 und 25 mA. Die Primärelektroden lassen sich bei der Weiterbildung beispielsweise um den Ionenstrahl herum anordnen.

Bei einer alternativen Weiterbildung ist die Primärelektrode bzw. sind die Primärelektroden quer zur Ausbreitungsrichtung des Ionenstrahls angeordnet, vorzugsweise in einem Winkel von 90°. Diese Anordnung wird insbesondere bei Anlagen verwendet, bei denen der Ionenstrahl beispielsweise gemäß einer Abtastbewegung geführt wird, d.h. gescannt wird. Insbesondere wird eine solche Abtastbewegung bei Mittelstrom-Ionenimplantierungsanlagen eingesetzt, bei denen der Ionenstrom Werte kleiner 1 mA hat. Jedoch gibt es auch Hochstrom-Ionenimplantierungsanlagen, bei denen der Ionenstrahl eine Abtastbewegung ausführt.

Beispielsweise lässt sich eine erfindungsgemäße Vorrichtung auf einfache Art und Weise in eine Ionenimplantieranlage vom Typ EATON Implanter einsetzen, insbesondere in einer Anlage vom Typ NV 8250 P. Die unten angegebenen Maße betreffen diesen Anlagentyp. Jedoch lassen sich auch andere Anlagentypen auf ähnliche Art und Weise verändern, um die Erfindung zu nutzen.

Im Folgenden werden Ausführungsbeispiele der Erfindung an Hand der beiliegenden Zeichnungen erläutert. Darin zeigen:

| | |
|---|---|
| Figur 1 | den Aufbau einer Erzeugungsvorrichtung für Sekundärelektronen mit Hilfe einer Koronaentladung, |
| Figuren 2A und 2B | Ansichten einer Sekundärelektrode, und |
| Figur 3 | eine Draufsicht auf eine Beschleunigungselektrode. |

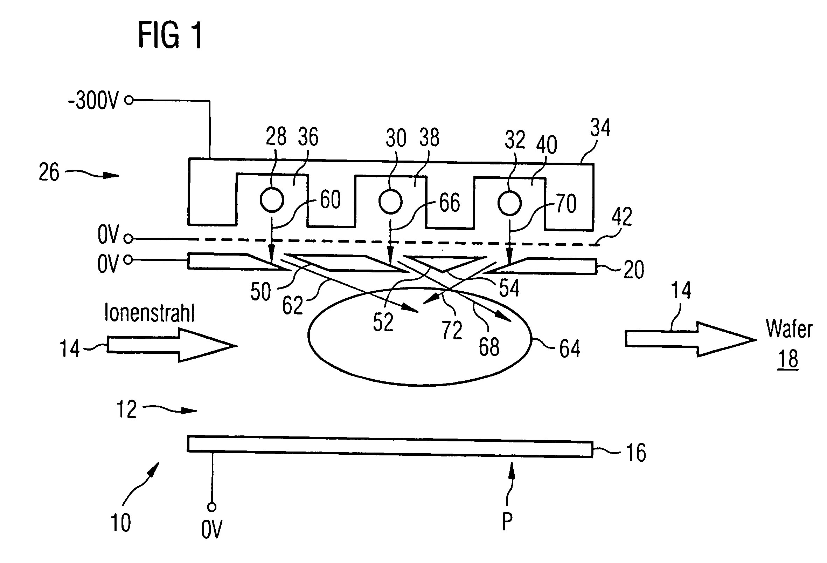

Figur 1 zeigt den Aufbau einer Elektronen-Erzeugungsvorrichtung 10, die einen Durchtrittsraum 12 bzw. eine Kammer für den Durchtritt eines Ionenstrahls 14 enthält. Der Ionenstrahl 14 wird mit Hilfe von nicht dargestellten Einheiten einer Ionenimplantieranlage erzeugt, nämlich mit:

- einer Ionenquelle, z.B. einer HF-Quelle (Hochfrequenz),
- einer Masseseparatoranordnung, z.B. einem Magneten, und
- einer Beschleunigungsstrecke.

Der Ionenstrahl 14 wird vor oder nach dem Durchtritt durch den Durchtrittsraum 12 beispielsweise mit Hilfe eines Ablenksystems abgelenkt, so dass er eine Abtastbewegung ausführt.

Der Durchtrittsraum 12 wird nach unten hin von einer abschirmenden Schwenkelektrode 16 begrenzt. Die Schwenkelektrode 16 ist um einen Punkt P schwenkbar gelagert. In einer Normalbetriebsart der Erzeugungsvorrichtung 10 befindet sich die Schwenkelektrode 16 in der in Figur 1 dargestellten Lage, d.h. der Ionenstrahl 14 kann ungehindert durch den Durchtrittsraum 12 treten. Während einer Testbetriebsart wird die Schwenkelektrode 16 nach oben in den Durchtrittsraum 12 geschwenkt, so dass der Ionenstrahl 14 nicht mehr auf einen Wafer 18 auftreffen kann.

Nach oben hin wird der Durchtrittsraum 12 von einer Sekundärelektrode 20 begrenzt, die sich parallel zu der Schwenkelektrode 16 in Normalbetriebsart erstreckt. Der Aufbau der Sekundärelektrode 20 wird unten näher erläutert.

An der Außenseite der Sekundärelektrode 20 ist in einem geringen Abstand eine Primärelektronen-Erzeugungsvorrichtung 26 angeordnet, die zum Erzeugen von Primärelektronen dient. Die Elektronenerzeugungsvorrichtung 26 enthält drei Glühdrähte 28, 30 und 32, die zueinander parallel z.B. in einem gleichmäßigen Abstandsraster aufgereiht sind. Die Glühdrähte 28, 30 und 32 verlaufen im Winkel von 90° zur Ausbreitungsrichtung des Ionenstrahls 14. Die Glühdrähte 28 bis 32 sind von einem Dreifachreflektor 34 umgeben, der drei voneinander getrennte Aussparungen 36, 38 und 40 hat, in deren Mitte sich jeweils ein Glühdraht 28, 30 bzw. 32 erstreckt. Den Öffnungen der Aussparungen 36 bis 40 gegenüberliegend befindet sich in einem geringen Abstand zum Dreifachreflektor 34 eine in einer Ebene liegende Beschleunigungselektrode 42, die beispielsweise ein durch Bohrungen gebildetes Gitter oder ein Drahtgitter ist.

Die Schwenkelektrode 16, die Sekundärelektrode 20 und die Beschleunigungselektrode 42 bestehen im Ausführungsbeispiel aus Aluminium. Die Glühdrähte 28 bis 32 bestehen beispielsweise aus Wolfram. Als Material für den Dreifachreflektor 34 ist ebenfalls Aluminium geeignet.

Die Sekundärelektrode 20 enthält drei schräg in der Sekundärelektrode 20 angeordnete Schlitze 50, 52 und 54, die in dieser Reihenfolge den Glühdrähten 28, 30 bzw. 32 benachbart sind. Damit liegen die Schlitze 50 und 52 näher am Eintrittsort des Ionenstrahls 14 in den Durchtrittsraum 12 als der Schlitz 54. Die Seitenwände der Schlitze 50 und 52 liegen parallel zueinander. So schließen die Seitenwände der Schlitze 50 und 52 mit einer Normalen der vom Durchtrittsraum 12 abgewandten Oberfläche der Sekundärelektrode 20 einen Winkel von -60° ein, wobei minus bedeutet, dass der Winkel von der Normalen in einer Richtung verläuft, die entgegengesetzt der Richtung des Uhrzeigers ist. Die Seitenwände des Schlitzes 54 liegen parallel zueinander, jedoch in einer Richtung geneigt, die der Neigungsrichtung der Seitenwände der Schlitze 50 und 52 entgegengesetzt ist. So schließen die Seitenwände des Schlitzes 54 mit einer Normalen der vom Durchtrittsraum 12 abgewandten Oberfläche der Sekundärelektrode 20 einen Winkel von +60° ein. Die Dicke der Sekundärelektrode 20 und der Winkel sind so bemessen, dass spitze Kanten der Schlitze 50, 52 und 54 jeweils zueinander in der Normalenrichtung der Oberfläche der Sekundärelektrode 20 fluchten. Eintrittsöffnungen der Schlitze 50, 52 und 54 sind in dieser Reihenfolgen den Glühdrähten 28, 30 bzw. 32 gegenüberliegend angeordnet.

An dem Dreifachreflektor 34 und an den Glühdrähten 28 bis 32 liegt ein Potential von -300 V (Volt) an. Eine diesem Potential überlagerte Spannung, insb. eine Gleichspannung, von bspw. 30 Volt, führt zu einem Stromfluss, der die Glühdrähte 28 bis 32 zum Glühen bringt. Durch die Glühdrähte 28 bis 32 fließen dann beispielsweise 5 A (Ampere) pro Glühdraht 28 bis 32. An der Schwenkelektrode 16, an der Sekundärelektrode 20 und an der Beschleunigungselektrode 42 liegt ein Potential von 0 V an. Somit werden beispielsweise Primärelektronen vom Glühfaden 28 zu der näher am Eintrittsort des Ionenstrahls 14 gelegenen Seitenfläche des Schlitzes 50 hin beschleunigt. Nach dem Durchtritt durch die Beschleunigungselektrode 42 treffen diese Primärelektronen 60 auf diese Seitenfläche auf und erzeugen dort jeweils ein Sekundärelektron. Die so entstehenden Sekundärelektronen 62 werden vom Ionenstrahl 14 angezogen und gelangen auf Grund der Richtwirkung des Schlitzes 50 auf einem zur Ausbreitungsrichtung des Ionenstrahls geneigten weg in eine Elektronenwolke 64.

Auf gleiche Art und Weise gelangen vom Glühdraht 30 durch die Beschleunigungselektrode 42 hindurch Primärelektronen 66 zu der näher am Eintrittsort des Ionenstrahls 14 liegenden Seitenfläche des Schlitzes 52. Die Primärelektronen 66 erzeugen Sekundärelektronen 68, die vom Ionenstrahl 14 angezogen werden und in die Elektronenwolke 64 gelangen.

Vom Glühdraht 32 aus werden Primärelektronen 70 zur Beschleunigungselektrode 42 hin beschleunigt. Die Primärelektronen 70 durchdringen die Beschleunigungselektrode 42 und gelangen auf die weiter weg vom Eintritt des Ionenstrahls 14 in dem Durchtrittsraum 12 gelegene Seitenfläche des Schlitzes 54. Die Primärelektronen 70 erzeugen Sekundärelektronen 72, die ebenfalls in die Elektronenwolke 64 gelangen. Während die Sekundärelektronen 62 und 68 hauptsächlich parallel zueinander in die Elektronenwolke 64 gelangen, sind die Sekundärelektronen 72 auf Grund der anderen Neigungsrichtung des Schlitzes 54 den Sekundärelektronen 62 und 68 entgegengerichtet. Auch zufällig durch den Schlitz 54 tretende Primärelektronen 70 werden durch die Neigung des Schlitzes 54 vom Wafer 18 weggerichtet.

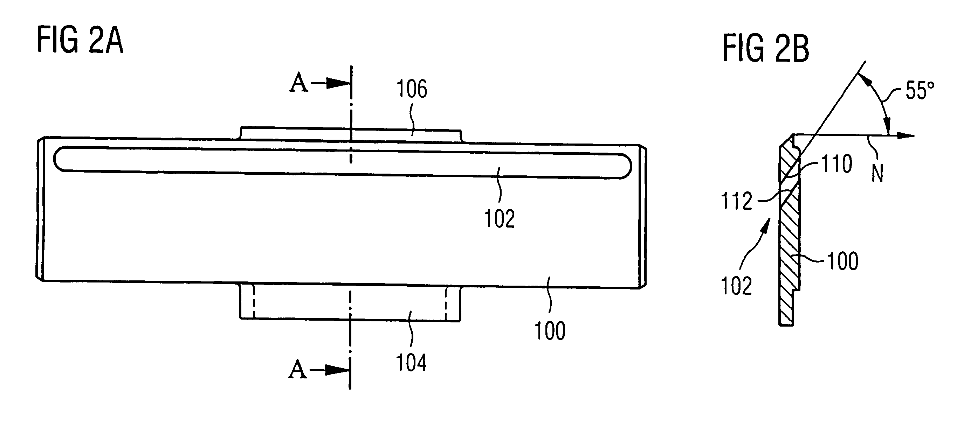

Figur 2A zeigt eine Sekundärelektrode 100 für einen EATON Implanter vom Typ NV-8250, d.h. insbesondere für 6-Zoll Waferimplantationen bzw. nach einem Umbau für 8-Zoll Waferimplantationen. Die Sekundärelektrode 100 wird an Stelle der Sekundärelektrode 20 in einer Elektronenerzeugungsvorrichtung eingesetzt, die nur einen Glühdraht enthält. Ein in der Sekundärelektrode 100 angeordneter Schlitz 102 entspricht beispielsweise dem Schlitz 50, 52 oder 54. Die Sekundärelektrode 100 hat einen rechteckförmigen Grundkörper, an dessen Längsseiten mittig zwei Befestigungsstege 104 und 106 angeordnet sind. Die Befestigungsstege 104 und 106 haben eine Länge, die etwa 1/3 der Länge des Grundkörpers der Sekundärelektrode 100 entspricht. Der Befestigungssteg 104 ragt etwa 10 mm über den Grundkörper der Sekundärelektrode 100 hinaus. Dagegen ragt der Befestigungssteg 106 nur etwa 3 mm über den Grundkörper der Sekundärelektrode 100 hinaus. Der Grundkörper der Sekundärelektrode 100 hat eine Länge von 162 mm und eine Breite von etwa 36 mm. Eine Öffnung des Schlitzes 102 erstreckt sich nahe an dem Befestigungssteg 106 entlang fast der gesamten Länge des Grundkörpers. Im Ausführungsbeispiel beträgt die Länge des Schlitzes 102 ohne Einbeziehungen von Rundungen an den Enden des Schlitzes 102 150 mm.

In Figur 2A ist außerdem die Lage einer Schnittebene A gezeigt, die quer zur Längsachse der Sekundärelektrode 100 in der Mitte der Sekundärelektrode 100 liegt.

Figur 2B zeigt die Sekundärelektrode 100 entlang des Querschnittes, der in der Schnittebene A liegt. Die Dicke der Sekundärelektrode 100 beträgt etwa 5 mm. Wie in Figur 2B dargestellt, liegen Seitenwände 110 und 112 des Schlitzes 102 zu einer Normalen N um einen Winkel von -55° geneigt. Der Abstand zwischen den Seitenwänden 110 und 112 beträgt 4 mm.

Die Sekundärelektrode 100 besteht aus Aluminium, nämlich aus dem Material Al 99. Die mittlere Rauheit der Oberfläche beträgt 6,3 $\mu$m.

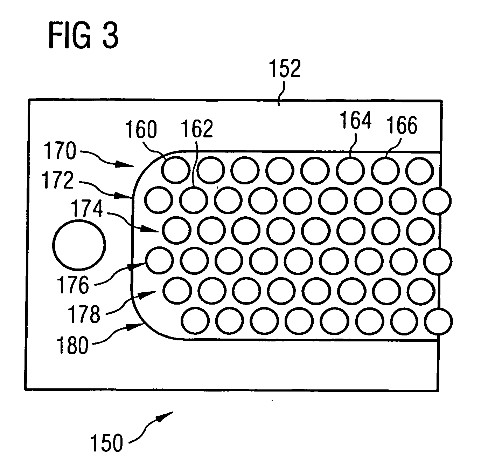

Figur 3 zeigt eine Beschleunigungselektrode 150, die an Stelle der Beschleunigungselektrode 42 in der gleichen Anlage eingesetzt wird, in der auch die Sekundärelektrode 100 verwendet wird. Die Beschleunigungselektrode 150 hat eine Länge von 162 mm und eine Breite von 11 mm. Innerhalb eines Rahmens 152 befinden sich eine Vielzahl von Bohrungen 160 bis 166, beispielsweise mehr als 500 Bohrungen. Die Bohrungen 160 bis 166 haben jeweils einen Durchmesser von 1 mm und sind in sechs zueinander parallel verlaufenden Reihen 170 bis 180 aufgereiht. Die Bohrungen 160, 162 zweier benachbarter Reihen 170, 172 sind um 0,65 mm zueinander versetzt. Die Abstände zwischen den inneren Reihen 174 und 176, zwischen den mittleren Reihen 172, 178 bzw. zwischen den äußeren Reihen 170 und 180 betragen 1,13 mm, 3,38 mm bzw. 5,63 mm. Innerhalb einer Reihe 170 bis 180 haben zueinander benachbarte Bohrungen 164, 166 einen auf den Mittelpunkt der Bohrungen 164 und 166 bezogenen Abstand von jeweils 1,3 mm.

Die Beschleunigungselektrode 150 ist in Figur 3 stark vergrößert dargestellt. Die Beschleunigungselektrode 150 besteht aus Aluminium Al 99.9, so dass nur eine kleine Anzahl von Fremdatomen aus der Beschleunigungselektrode 150 austritt. Implantationsverfahren lassen sich so mit einer hohen Ausbeute durchführen. Die mittlere Rauheit der Oberfläche beträgt 4,3 $\mu$m. Die Dicke des Rahmens 152 beträgt 1,5 mm. Innerhalb des Rahmens 152 ist die Beschleunigungselektrode 150 l mm dick.

Bei einem Beispiel, das nicht Gegenstand der Erfindung ist, wird bei der Elektronen-Erzeugungsvorrichtung 10 die Beschleunigungselektrode 42 weggelassen. Die Funktionen der Beschleunigungselektrode 42 werden dann zusätzlich von der Sekundärelektrode 20 übernommen.

Bei einem weiteren Ausführungsbeispiel werden an Stelle der schrägen Schlitze Lamellen verwendet, die bspw. in einem Rahmen gehalten werden. Jeweils zwei benachbarte Lamellen bilden eine Durchgangsöffnung, die sich schräg durch den Rahmen erstreckt. Jede Lamelle ist ein langgestrecktes dünnes Metallplättchen, bspw. aus Aluminium.

**Patentansprüche**

1. Vorrichtung (10) zum Erzeugen von Sekundärelektronen um Aufladungen in einer Ionenimplantationsanlage zu verhindern, mit mindestens einer Primärelektrode (28 bis 32) zum Erzeugen von Primärelektronen (60), mit einer Beschleunigungselektrode (42) zum Beschleunigen der Primärelektronen, und mit einer Sekundärelektrode (20, 100) zum Erzeugen von Sekundärelektronen beim Auftreffen der beschleunigten Primärelektronen, wobei die Sekundärelektrode (20, 100) mindestens eine Durchgangsöffnung (50) enthält, die sich schräg durch die Sekundärelektrode (20, 100) hindurch erstreckt und die den Durchtritt von Primärelektronen (60) behindert, wobei an die Beschleunigungselektrode (42) und an die Sekundärelektrode (20, 100) ein Potential von 0 Volt angelegt ist, und wobei die Sekundärelektrode (20, 100) auf der von der Primärelektrode (28 bis 32) abgewandten Seite der Beschleunigungselektrode (42) angeordnet ist, und wobei die Beschleunigungselektrode (150) mindestens 100 Öffnungen enthält.

2. Vorrichtung (10) nach Anspruch 1, **dadurch gekennzeichnet, dass** die Durchgangsöffnung (50, 102) durch ein Langloch mit vorzugsweise parallel zueinander angeordneten Seitenflächen (110, 112) oder durch Lamellen gebildet wird, und/oder dass sich Seitenflächen (110, 112) der Durchgangsöffnung (102) in Auftreffrichtung von in die Durchgangsöffnung (102) gelangenden Primärelektronen (60) überlappen oder fluchtend zur Normalenrichtung (N) der die Durchgangsöffnung (102) enthaltenden Fläche angeordnet sind.

3. Vorrichtung (10) nach Anspruch 1 oder 2, **dadurch gekennzeichnet, dass** die Durchgangsöffnung (50) eine Durchgangsrichtung hat, die zur Flächennormalen (N) der Sekundärelektrode (100) im Bereich der Durchgangsöffnung (50) in einem Winkel mit einem Betrag zwischen 30° und 70° angeordnet ist, vorzugsweise in einem Winkel mit einem Betrag von 55°, und/oder dass für den Winkel gilt:

$$\tan(90°-w) = d/b,$$

wobei w den Winkel, d die Dicke der Elektrode mit der Durchgangsöffnung (50) und b die Breite der Durchgangsöffnung (50) bei Draufsicht entgegen der Flächennormalen (N) bezeichnen, und/oder dass der Abstand von Seitenwänden (110, 112) der Durchgangsöffnung (50) zwischen 2 mm und 6 mm liegt, vorzugsweise bei 4 mm.

4. Vorrichtung (10) nach einem der vorhergehenden Ansprüche, **dadurch gekennzeichnet, dass** mehrere Primärelektroden (28 bis 32) vorhanden sind, denen jeweils mindestens eine Durchgangsöffnung (50 bis 54) zugeordnet ist, wobei vorzugsweise mindestens zwei Durchgangsöffnungen (50, 54) voneinander verschiedene Schräglagen haben.

5. Vorrichtung (10) nach Anspruch 4, **dadurch gekennzeichnet, dass** pro Primärelektrode (28 bis 32) nur jeweils eine Durchgangsöffnung (50 bis 54) vorgesehen ist.

6. Vorrichtung (10) nach einem der Ansprüche 1 bis 3, **dadurch gekennzeichnet, dass** die Vorrichtung (10) nur eine Primärelektrode (28) enthält.

7. Vorrichtung (10) nach Anspruche 6, **dadurch gekennzeichnet, dass** nur eine Durchgangsöffnung (50 bis 54) vorgesehen ist.

8. Vorrichtung (10) nach einem der vorhergehenden Ansprüche, **dadurch gekennzeichnet, dass** die Sekundärelectrode (20, 100) aus Aluminium oder einer Aluminiumlegierung besteht, vorzugsweise aus Al 99 oder einem noch reineren Aluminium, oder dass die Sekundärelektrode aus Graphit besteht oder mehr als 60 Masseprozent Graphit enthält,

oder dass die Sekundärelectrode (20, 109) Aluminiumoxid enthält,
und/oder dass die Sekundärelektrode (20, 100) eine mittlere Oberflächenrauheit zwischen 5 und 8 µm hat.

9.  Vorrichtung (10) nach einem der vorhergehenden Ansprüche, **dadurch gekennzeichnet, dass** die Beschleunigungselektrode (150) mindestens 500 oder mindestens 1000 Öffnungen (160 bis 166) enthält, vorzugsweise Bohrungen oder Maschen in einem Drahtgitter.

10. Vorrichtung (10) nach Anspruch 9, **dadurch gekennzeichnet, dass** die Beschleunigungselektrode (150) aus Aluminium oder einer Aluminiumlegierung besteht, vorzugsweise aus A1 99.9 oder einem noch reineren Aluminium, und/oder dass die mittlere Oberflächenrauheit der Beschleunigungselektrode (150) kleiner als die mittlere Oberflächenrauheit der Sekundarelektrode (20, 100) ist und vorzugsweise in dem Bereich zwischen 2,5 und 6 µm liegt.

11. Verwendung der Vorrichtung (10) nach einem der vorhergehenden Ansprüche, angeordnet an einen Freiraum (12), der zum Durchtritt eines Ionenstrahls (14) verwendet wird, wobei der Ionenstrahl (14) vorzugsweise auf ein Werkstück gerichtet wird, insbesondere auf ein Halbleitersubstrat (18),
oder der zur Aufnahme eines Plasmas dient,
und/oder der zur Aufnahme eines zu bearbeitenden Materials oder Werkstücks dient.

12. Verwendung der Vorrichtung nach Anspruch 11, **dadurch gekennzeichnet, dass** die Primärelektrode parallel zur Ausbreitungsrichtung des Ionenstrahls (14) angeordnet ist,
oder dass die Primärelektrode (28) quer zur Ausbreitungsrichtung des Ionenstrahls (14) angeordnet ist.


**Claims**

1.  Apparatus (10) for production of secondary electrons in order to prevent charges in an ion implantation system, having at least one primary electrode (28 to 32) for production of primary electrons (60),
having an acceleration electrode (42) for acceleration of the primary electrons,
and having a secondary electrode (20, 100) for production of secondary electrons when accelerated primary electrons arrive, the secondary electrode (20, 100) containing at least one aperture opening (50) which extends obliquely through the secondary electrode (20, 100) and prevents primary electrons (60) from passing through, there being a potential of 0 V on the acceleration electrode (42) and on the secondary electrode (20, 100), and the secondary electrode (20, 100) being arranged on that side of the acceleration electrode (42) which faces away from the primary electrode (28 to 32), and the acceleration electrode (150) containing at least 100 openings.

2.  Apparatus (10) according to Claim 1, **characterized in that** the aperture opening (50, 102) is formed by an elongated hole with side surfaces (110, 112) which are preferably arranged parallel to one another, or by laminates, and/or **characterized in that** side surfaces (110, 112) of the aperture opening (102) overlap in the arrival direction of primary electrons (60) which pass into the aperture opening (102), or are arranged aligned with the normal direction (N) of the surface which contains the aperture opening (102).

3.  Apparatus (10) according to either of Claims 1 and 2, **characterized in that** the aperture opening (50) has an aperture direction which is arranged at an angle with a magnitude of between 30° and 70°, preferably at an angle with a magnitude of 55°, to the surface normal (N) of the secondary electrode (100) in the area of the aperture opening (50),
and/or **characterized in that** the angle is defined by:

$$\tan\,(90°\,-w)\,=\,d/b,$$

where, in a plan view against the surface normal (N), w is the angle, d is the thickness of the electrode with the aperture opening (50), and b is the width of the aperture opening (50),
and/or **characterized in that** the distance between the side walls (110, 112) of the aperture opening (50) is between 2 mm and 6 mm, preferably 4 mm.

4.  Apparatus (10) according to one of the preceding claim, **characterized in that** two or more primary electrodes (28 to 32) are present, each of which has at least one associated aperture opening (50 to 54),

with at least two aperture openings (50, 54) preferably being at different inclination angles to one another.

5. Apparatus (10) according to Claim 4, **characterized in that** in each case only one aperture opening (50 to 54) is provided for each primary electrode (28 to 32).

6. Apparatus (10) according to one of Claims 1 to 3, **characterized in that** the apparatus (10) contains only one primary electrode (28).

7. Apparatus (10) according to Claim 6, **characterized in that** only one aperture opening (50 to 54) is provided.

8. Apparatus (10) according to one of the preceding claims, **characterized in that** the secondary electrode (20, 100) is composed of aluminium or of an aluminium alloy, preferably of A1 99 or of an even purer aluminium, or that the secondary electrode is composed of graphite or contains at least 60% by mass of graphite, or that the secondary electrode (20, 100) contains aluminium oxide, and/or that the secondary electrode (20, 100) has a mean surface roughness of between 5 and 8 $\mu$m.

9. Apparatus (10) according to one of the preceding claims, **characterized in that** the acceleration electrode (150) contains at least 500 openings or at least 1000 openings (160 to 166), preferably holes or meshes in a wire mesh.

10. Apparatus (10) according to Claim 9, **characterized in that** the acceleration electrode (150) is composed of aluminium or of an aluminium alloy, preferably of A1 99.9 or of an even purer aluminium, and/or **characterized in that** the mean surface roughness of the acceleration electrode (150) is less than the mean surface roughness of the secondary electrode (20, 100), and is preferably in the range between 2.5 and 6 $\mu$m.

11. Use of the apparatus (10) according to one of the preceding claims, arranged in a free space (12) which is used for an ion beam (14) to pass through, with the ion beam (14) preferably being directed at a workpiece, in particular at a semiconductor substrate (18), or which is used to hold a plasma, and/or which is used to hold a material or workpiece to be processed.

12. Use of the apparatus according to Claim 11, **characterized in that** the primary electrode is arranged parallel to the propagation direction of the ion beam (14), or **characterized in that** the primary electrode (28) is arranged transversely with respect to the propagation direction of the ion beam (14).

**Revendications**

1. Dispositif (10) de production d'électrons secondaires pour empêcher des charges dans une installation d'implantation d'ions, comprenant au moins une électrode (28 à 32) primaire de production d'électrons (60) primaires, comprenant une électrode (42) d'accélération pour accélérer les électrons primaires, et comprenant une électrode (20, 100) secondaire de production d'électrons secondaires lors d'un choc des électrons primaires accélérés, dans lequel l'électrode (20, 100) secondaire comporte au moins une ouverture (50) de passage qui s'étend en étant inclinée à travers l'électrode (20, 100) secondaire et qui empêche le passage d'électrons (60) primaires, dans lequel il est appliqué sur l'électrode (42) d'accélération et sur l'électrode (20, 100) secondaire un potentiel de 0 volt, et dans lequel l'électrode (20, 100) secondaire est disposée du côté de l'électrode (42) d'accélération, éloigné de l'électrode (28 à 32) primaire, et dans lequel l'électrode (150) d'accélération comporte au moins 100 ouvertures.

2. Dispositif (10) suivant la revendication 1, **caractérisé en ce que** l'ouverture (50, 102) de passage est formée par un trou oblong ayant des surfaces (110, 112) latérales disposées de préférence parallèlement entre elles ou par des lamelles, et/ou **en ce que** des surfaces (110, 112) latérales de l'ouverture (102) de passage se chevauchent dans la direction de choc d'électrons (60) primaires arrivant dans l'ouverture (102) de passage ou sont alignées avec la direction (N) normale à la surface comportant l'ouverture (102) de passage.

3. Dispositif (10) suivant la revendication 1 ou 2, **caractérisé en ce que** l'ouverture (50) de passage a un sens de passage qui est disposé par rapport à la normale (N) à la surface de l'électrode (100) secondaire dans la région de l'ouverture (50) de passage suivant un angle d'une valeur comprise entre 30° et 70°, de préférence suivant un angle ayant une valeur absolue de 55° et/ou **en ce que** pour l'angle on a :

$$\tan (90° - w) = d/b$$

dans laquelle w est l'angle, d est l'épaisseur de l'électrode ayant l'ouverture (50) de passage et b est la largeur de l'ouverture (50) de passage considérée dans la vue en plan par rapport à la normale (N) à la surface et/ou **en ce que** la distance entre les parois (110, 112) latérales de l'ouverture (50) de passage est comprise entre 2 mm et 6 mm, en étant de préférence de 4 mm.

4. Dispositif (10) suivant l'une des revendications précédentes, **caractérisé en ce qu'**il y a plusieurs électrodes (28 à 32) primaires auxquelles sont associées respectivement au moins une ouverture (50 à 54) de passage, dans lequel de préférence au moins deux ouvertures (50, 54) de passage ont des positions inclinées différentes l'une de l'autre.

5. Dispositif (10) suivant la revendication 4, dans lequel il est prévu respectivement qu'une ouverture (50 à 54) de passage par électrode (28 à 32) primaire.

6. Dispositif (10) suivant l'une des revendications 1 à 3, **caractérisé en ce que** le dispositif (10) ne comporte qu'une électrode (28) primaire.

7. Dispositif (10) suivant la revendication 6, **caractérisé en ce qu'**il n'est prévu qu'une ouverture (50 à 54) de passage.

8. Dispositif (10) suivant l'une des revendications précédentes, **caractérisé en ce que** l'électrode (20, 100) secondaire est en aluminium ou en alliage d'aluminium, de préférence en Al 99 ou en un alliage encore plus pur,
ou **en ce que** l'électrode secondaire est en graphite ou contient du graphite à plus de 60 % en poids,
ou **en ce que** l'électrode (20, 100) secondaire contient de l'oxyde d'aluminium,
et/ou **en ce que** l'électrode (20, 100) secondaire a une rugosité moyenne de surface comprise entre 5 et 8 $\mu$m.

9. Dispositif (10) suivant l'une des revendications précédentes, **caractérisé en ce que** l'électrode (150) d'accélération a au moins 500 ou au moins 1 000 ouvertures (160 à 166), de préférence des trous ou des mailles dans un réseau de fil métallique.

10. Dispositif (10) suivant la revendication 1, **caractérisé en ce que** l'électrode (150) d'accélération est en aluminium ou en un alliage d'aluminium, de préférence en Al 99,9 ou en un aluminium encore plus pur, et/ou **en ce que** la rugosité moyenne de surface de l'électrode (150) d'accélération est plus petite que la rugosité moyenne de surface de l'électrode (20, 100) secondaire et, de préférence, est dans la plage comprise entre 2,5 et 6 $\mu$m.

11. Utilisation du dispositif (10) suivant l'une des revendications précédentes, disposé sur un espace (12) libre qui est utilisé pour le passage d'un faisceau capteur d'ions, le faisceau capteur d'ions étant dirigé, de préférence sur une pièce, notamment sur un substrat (18) semi-conducteur,
ou qui sert à recevoir un plasma,
et/ou qui sert à la réception d'un matériau ou d'une pièce à usiner.

12. Utilisation du dispositif (10) suivant l'une des revendications précédentes, utilisation du dispositif suivant la revendication 11, **caractérisée en ce** l'électrode primaire est disposée parallèlement à la direction de propagation du faisceau (14) d'ions,
ou en ce que l'électrode (28) primaire est disposée transversalement à la direction de propagation du faisceau (14) d'ions.

EP 1 422 740 B1

# FIG 1

-300V

26

28 36    30 38    32 40    34

60    66    70

0V

0V    42

50    62    52    72    68    54    64    20

Ionenstrahl

14    14

Wafer
18

12

16

10    0V    P

# FIG 2A

A →

106

102

100

A →

104

# FIG 2B

55°

110

112

N

102

100

EP 1 422 740 B1

# FIG 3

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 6043499 A
- JP 6267493 A
- US 5164599 A
- US 4914292 A
- US 3395306 A
- JP 62058536 A
- DE 2707416 A1
- US 3976905 A
- GB 503211 A